Europäisches Patentamt

**European Patent Office**

**Office européen des brevets**

(19)

(11) Numéro de publication: **0 139 549 B1**

(12)

# FASCICULE DE BREVET EUROPEEN

(45) Date de publication du fascicule du brevet:
**28.12.88**

(21) Numéro de dépôt: **84401636.0**

(22) Date de dépôt: **06.08.84**

(51) Int. Cl.⁴: **H 01 L 21/90,** H 01 L 21/60,
H 01 L 23/52, H 01 L 21/00

(54) Procédé de positionnement d'une ligne d'interconnexion sur un trou de contact électrique d'un circuit intégré.

(30) Priorité: **12.08.83 FR 8313282**

(43) Date de publication de la demande:
**02.05.85 Bulletin 85/18**

(45) Mention de la délivrance du brevet:
**28.12.88 Bulletin 88/52**

(84) Etats contractants désignés:
**CH DE GB IT LI NL**

(56) Documents cités:
**EP-A- 0 049 400**
**EP-A- 0 071 010**
**FR-A- 2 321 190**
**FR-A- 2 428 915**

**IBM TECHNICAL DISCLOSURE BULLETIN, vol. 13, no. 1,
juin 1970, page 38, New York, US; H.A. KHOURY et al.:
"Anti-interference phenomena coating"**

(73) Titulaire: **COMMISSARIAT A L'ENERGIE ATOMIQUE,
31/33, rue de la Fédération, F-75015 Paris (FR)**

(72) Inventeur: **Jeuch, Pierre, 13, Rue du Parc,
F-38170 Seyssins (FR)**

(74) Mandataire: **Mongrédien, André et al, c/o
BREVATOME 25, rue de Ponthieu, F-75008 Paris (FR)**

ACTORUM AG

## Description

La présente invention a pour objet un perfectionnement au procédé de positionnement d'une ligne d'interconnexion sur un trou de contact électrique d'un circuit intégré, décrit dans FR-A-2525389, publié le 21.10.1983.

Le procédé décrit dans cette demande de brevet est un procédé de positionnement d'une ligne d'interconnexion sur un trou de contact électrique d'un circuit intégré, dans lequel le trou de contact électrique étant réalisé, on effectue les étapes successives suivantes:

- dépôt sur l'ensemble du circuit intégré d'une couche conductrice dans laquelle sera réalisée la ligne d'interconnexion,

- dépôt sur la couche conductrice d'une couche d'isolant effaçant le relief de celle-ci et présentant une surface plane,

- réalisation d'une gravure de la couche d'isolant afin de ne laisser de l'isolant qu'à l'emplacement du trou de contact électrique,

- dépôt d'une couche de résine sur le circuit intégré de façon à masquer la ligne d'interconnexion à réaliser,

- réalisation d'une gravure de la partie de la couche conductrice dépourvue à la fois de résine et de la couche d'isolant restante, et

- élimination de la couche d'isolant restante et de la couche de résine.

Selon un mode préféré de réalisation de ce procédé, la couche d'isolant est une couche de résine.

Ce procédé qui permet un auto-positionnement de la ligne d'interconnexion sur le trou de contact électrique a pour inconvénient que la précision de la réalisation des gravures des lignes conductrices n'est pas très grande.

En effet, dans ce procédé, on réalise dans la couche de résine photosensible l'image des interconnexions selon les procédés classiques de la photolithographie. La nature réflectrice de la couche à graver (couche métallique) produit des interférences dans la couche de résine photosensible, ce qui dégrade la qualité de l'image des interconnexions et produit en particulier des variations de largeur de trait aux passages de marche.

La présente invention a justement pour objet un procédé qui supprime ces inconvénients en utilisant entre la couche photosensible et la couche d'isolant une couche intermédiaire réalisée de préférence en silice ($SiO_2$) ou en silicium amorphe.

Le procédé de positionnement d'une ligne d'interconnexion sur un trou de contact électrique d'un circuit intégré conformément à l'invention, comprend les étapes successives suivantes:

- dépôt sur l'ensemble du circuit intégré d'une couche conductrice dans laquelle sera réalisée la ligne d'interconnexion, cette couche conductrice ayant une épaisseur constante et présentant un creux en regard du trou de contact électrique,

- dépôt sur la couche conductrice d'une couche d'isolant effaçant le relief de ladite couche conductrice et présentant une surface plane,

- dépôt d'une couche intermédiaire de la couche d'isolant, de nature différente de celle de la couche d'isolant et présentant des propriétés réfléchissantes inférieures à celles de la couche conductrice,

- dépôt d'une couche de résine photosensible sur la couche intermédiaire et réalisation dans cette couche de résine de l'image de la ligne d'interconnexion à réaliser,

- gravure de la région de la couche intermédiaire dépourvue de masque,

- élimination du masque et gravure de la couche d'isolant dans les régions non protégées par la couche intermédiaire, cette gravure étant arrêtée dès que la région de la couche conductrice située en dehors du trou de contact est mise à nu,

- réalisation d'une gravure de la partie de la couche conductrice dépourvue à la fois des couches d'isolant et intermédiaire, et

- élimination des couches d'isolant et intermédiaire restantes.

Selon un mode préféré de mise en œuvre du procédé selon l'invention, la gravure de la couche intermédiaire est une gravure ionique réactive.

Selon un autre mode préféré de mise en œuvre du procédé selon l'invention, la couche intermédiaire est de la silice.

Selon un autre mode préféré de mise en œuvre du procédé selon l'invention, la couche intermédiaire est du silicium amorphe.

Selon un autre mode préféré de mise en œuvre du procédé selon l'invention, l'élimination du masque et la gravure de la couche d'isolant est réalisée au moyen d'une gravure ionique réactive à base d'oxygène.

D'autres caractéristiques et avantages de l'invention ressortiront mieux de la description qui va suivre, donnée à titre illustratif mais nullement limitatif en référence aux figures annexées sur lesquelles:

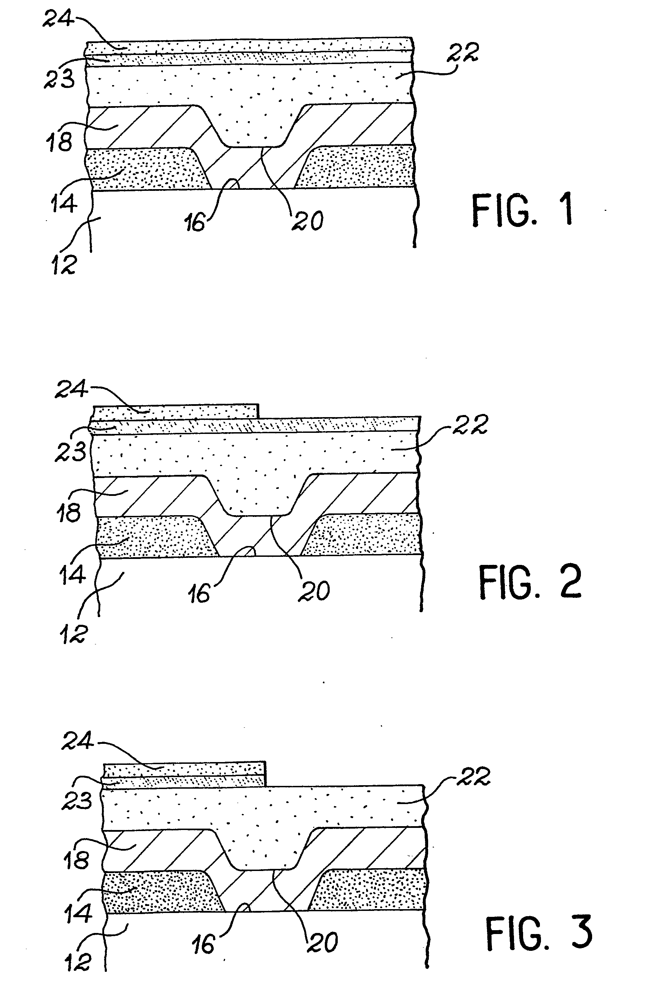

- les figures 1 à 6 représentent, schématiquement, les différentes étapes du procédé conformément à l'invention.

Sur la figure 1, on a représenté une partie d'un circuit intégré comprenant une zone active 12, semiconductrice dopée, correspondant par exemple à la source ou au drain d'un transistor MOS que l'on veut connecter électriquement à une autre zone active (non représentée) du circuit intégré. De façon classique, cette zone active 12 est recouverte d'une couche isolante 14 généralement réalisée en silice pouvant contenir 5 à 10% de phosphore. Cette couche de silice présente par exemple une épaisseur de 0,8 micron. Cette couche de silice 14 est ensuite gravée, en utilisant un masque de résine réalisé par photolithographie sur cette couche, par exemple, par une attaque chimique (HF dilué) de façon à réaliser le trou de contact électrique 16 de la zone active 12.

Après réalisation du trou de contact électrique 16, on dépose de façon connue, par exemple par la technique de dépôt par pulvérisation magnétron sur l'ensemble du circuit intégré une couche conductrice 18, réalisée de préférence en aluminium. Cette couche conductrice 18 qui possède une épaisseur constante par exemple voisine de 1 micromètre, présente un profil dépendant des couches sous-jacentes; elle présente en particulier un creux 20 au niveau du trou de contact électrique 16.

Selon un mode préféré de mise en œuvre de l'invention, on dépose de façon classique une couche d'isolant 22 sur l'ensemble de la couche conductrice 18 de façon qu'elle présente une surface plane. Cette couche d'isolant est réalisée de préférence en résine, telle que celles utilisées usuellement en photolithographie. Dans le cas d'une couche d'isolant réalisé en résine, celle-ci pourra être déposée par centrifugation selon la technique usuellement employée pour déposer les résines photosensibles dans les opérations de photolithographie (procédé dit «de la tournette»). Selon la viscosité de la résine utilisée, on procédera avantageusement à un traitement thermique, après dépôt de la résine à une température permettant d'obtenir une surface aussi plane que possible grâce à un fluage de cette couche de résine 22.

Une résine photosensible pourra être par exemple chauffée à une température de 150 à 200°C.

La couche de résine 22 étant réalisée, on dépose dessus une couche 23 intermédiaire de préférence en $SiO_2$ ou en Si amorphe d'une épaisseur de 0,1 à 0,2 µm par exemple.

Sur la couche intermédiaire 23, on dépose une couche 24 de résine photosensible d'une épaisseur de l'ordre de 0,2 à 0,5 µm.

Cette couche photosensible permet de réaliser un masquage avec une grande fidélité, car elle est peu épaisse et déposée sur une surface plane formée par un substrat qui est un mauvais réflecteur optique.

Ce dernier permet d'éviter la création d'interférences optiques qui sont responsables d'une diminution de la résolution optique.

Comme le montre la figure 2, l'étape suivante du procédé de positionnement consiste à réaliser dans la couche de résine photosensible l'image de la ligne d'interconnexion.

L'étape suivante, comme représenté sur la figure 3, consiste à graver la couche intermédiaire 23. Cette gravure est de préférence ionique réactive, utilisant du $CHF_3$ si le matériau de la couche intermédiaire 23 est du $SiO_2$.

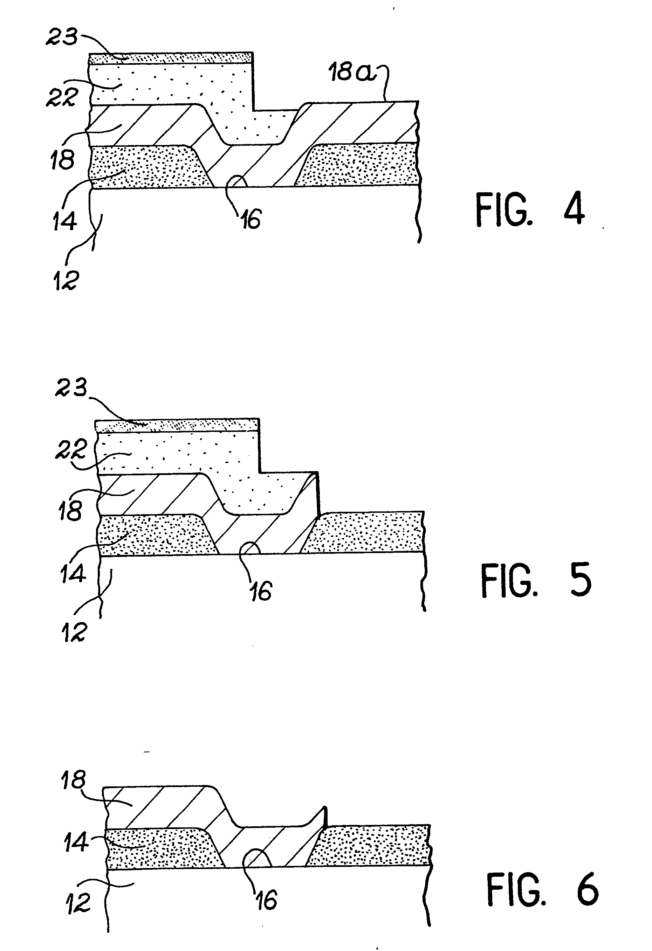

Comme le représente la figure 4, l'étape suivante consiste à graver la partie de la couche en résine 22 dépourvue de la couche intermédiaire 23 et à éliminer à la fois des résidus de la couche de résine photosensible 24 restant sur la couche intermédiaire 23.

La gravure de cette partie de la couche 22 ne laisse de l'isolant qu'à la partie de l'emplacement du trou de contact électrique et dans les parties protégées par la couche 23. Cette gravure peut être réalisée par exemple à l'aide d'un procédé de gravure sèche utilisant un plasma d'oxygène.

Comme représenté sur la figure 5, l'étape suivante du procédé de positionnement consiste à graver la partie 18a de la couche conductrice 18 dépourvue à la fois de la couche intermédiaire 23 et des résidus de la couche de résine 22, la couche 23 et la couche de résine 22 servant de masque à ladite gravure. Cette gravure peut être réalisée de façon isotrope par une simple attaque chimique dans une solution contenant de l'acide phosphorique $H_3PO_4$, dans le cas d'une couche conductrice 18 réalisée en aluminium. Dans le cas de dimensions très petites, on utilisera, de préférence, un procédé de gravure anisotrope utilisant un plasma composé par exemple des composés tels que le $CCl_4$.

La dernière étape du procédé consiste à éliminer les couches de résine 22 et intermédiaire 23 restantes. Les résidus de la couche 23 peuvent être éliminés par une attaque chimique avec du HF dilué, si elle est en $SiO_2$. La couche de résine 22 peut être éliminée par exemple par un plasma d'oxygène. La structure obtenue est représentée sur la figure 6.

Le procédé de positionnement décrit précédemment permet d'effectuer la gravure de la ligne d'interconnexion avec une haute précision car l'image faite dans la résine photosensible 24 est transférée avec une grande fidélité dans la couche intermédiaire puis dans la couche de résine épaisse qui masque elle-même la gravure de la couche conductrice.

## Revendications

1. Procédé de positionnement d'une ligne d'interconnexion sur un trou de contact électrique (16) d'un circuit intégré, comprenant les étapes successives suivantes:

- dépôt sur l'ensemble du circuit intégré d'une couche conductrice (18) dans laquelle sera réalisée la ligne d'interconnexion, cette couche conductrice ayant une épaisseur constante et présentant un creux en regard du trou de contact électrique (16),

- dépôt sur la couche conductrice (18) d'une couche d'isolant (22) effaçant le relief de ladite couche conductrice et présentant une surface plane,

- dépôt d'une couche intermédiaire (23) sur la couche d'isolant (22), de nature différente de celle de la couche d'isolant (22), et présentant des propriétés réfléchissantes inférieures à celles de la couche conductrice (18),

- dépôt d'une couche de résine photosensible (24) sur la couche intermédiaire (23) et réalisation dans cette couche de résine de l'image de la ligne d'interconnexion à réaliser,

- gravure de la région de la couche intermédiaire (23), dépourvue de masque,

- élimination du masque et gravure de la couche d'isolant (22), cette gravure étant arrêtée dès que la région de la couche conductrice (18a) située en dehors du trou de contact est mise à nu,

- réalisation d'une gravure de la partie de la couche conductrice (18a) dépourvue à la fois des couches d'isolant (22) et intermédiaire (23), et

- élimination des couches d'isolant (22) et intermédiaire (23) restantes.

2. Procédé selon la revendication 1, caractérisé en ce que la gravure de la couche intermédiaire (23) est une gravure ionique réactive.

3. Procédé selon la revendication 1, caractérisé en ce que la couche intermédiaire (23) est de la silice.

4. Procédé selon la revendication 1, caractérisé en ce que la couche intermédiaire (23) est du silicium amorphe.

5. Procédé selon la revendication 1, caractérisé en ce que l'élimination du masque et la gravure de la couche d'isolant (22) sont réalisées au moyen d'une gravure ionique réactive à base d'oxygène.

## Claims

1. Process for the positioning of an interconnection line on an electrical contact hole (16) of an integrated circuit, comprising the following successive stages:
- depositing on the complete integrated circuit a conductive coating (18) in which will be formed the interconnection line, said conductive coating having a constant thickness and a relief facing the electrical contact hole (16),
- deposition on the conductive coating (18) of an insulating coating (22) obliterating the relief of said conductive coating and having a planar surface,
- deposition of an intermediate coating (23) on the insulating coating (22) and which is of a different nature from the latter, whilst having reflecting properties inferior to those of the conductive coating (18),
- deposition of a photosensitive resin coating (24) on the intermediate coating (23) and producing in said resin coating the image of the interconnection line to be produced,
- etching the region of the intermediate coating (23) free from the mask,
- elimination of the mask and etching the insulating coating (22), said etching being stopped as soon as the region of the conductive coating (18a) outside the contact hole is exposed,
- etching that part of the conductive coating (18a) which is free from both the insulating (22) and intermediate (23) coatings,
- elimination of the residual insulating (22) and intermediate (23) coatings.

2. Process according to claim 1, characterized in that the etching of the intermediate coating (23) is reactive ionic etching.

3. Process according to claim 1, characterized in that the intermediate coating (23) is of silica.

4. Process according to claim 1, characterized in that the intermediate coating (23) ist of amorphous silicon.

5. Process according to claim 1, characterized in that the elimination of the mask and the etching of the insulating coating (22) are performed by oxygen-based reactive ionic etching.

## Patentansprüche

1. Verfahren zum Positionieren einer Verbindungsleitung über einer elektrischen Kontaktöffnung (16) einer integrierten Schaltung, umfassend die folgenden aufeinanderfolgenden Schritte:

Aufbringen einer leitfähigen Schicht (18), in der die Verbindungsleitung hergestellt werden soll, auf der integrierten Schaltungsanordnung, wobei diese leitfähige Schicht eine gleichmässige Dicke hat und gegenüber der elektrischen Kontaktöffnung (16) eine Vertiefung hat,

Ausbilden einer Isolierschicht (22) auf der leitfähigen Schicht (18), die das Relief der genannten leitfähigen Schicht auslöscht und eine ebene Oberfläche hat,

Ausbilden einer Zwischenschicht (23) auf der Isolierschicht (22) in einer von der der Isolierschicht (22) abweichenden Art, die geringere Reflexionseigenschaften aufweist, als die leitfähige Schicht (18),

Aufbringen einer fotoempfindlichen Harzschicht (24) auf der Zwischenschicht (23) und Belichten dieser Harzschicht mit dem Abbild der herzustellenden Verbindungsleitung,

Ätzen des durch eine Maske entblössten Bereiches der Zwischenschicht (23),

Beseitigen der Maske und Ätzen der Isolierschicht (22), wobei diese Ätzung abgebrochen wird, sobald der Bereich der leitfähigen Schicht (18a), der über dem Kontaktloch liegt, blossgelegt ist,

Ausführung einer Ätzung des blossgelegten Teils der leitfähigen Schicht (18a) zusammen mit der Isolierschicht (22) und der Zwischenschicht (23), und

Beseitigen der verbliebenen Isolierschicht (22) und Zwischenschicht (23).

2. Verfahren nach Anspruch 1, dadurch gekennzeichnet, dass die Ätzung der Zwischenschicht (23) eine reaktive ionische Ätzung ist.

3. Verfahren nach Anspruch 1, dadurch gekennzeichnet, dass die Zwischenschicht (23) aus Siliciumoxid besteht.

4. Verfahren nach Anspruch 1, dadurch gekennzeichnet, dass die Zwischenschicht (23) aus amorphem Silicium besteht.

5. Verfahren nach Anspruch 1, dadurch gekennzeichnet, dass die Beseitigung der Maske und die Ätzung der Isolierschicht (22) mittels einer reaktiven ionischen Ätzung auf Sauerstoffbasis ausgeführt werden.

FIG. 1

FIG. 2

FIG. 3

23

22

18a

18

14

12

16

FIG. 4

23

22

18

14

12

16

FIG. 5

18

14

12

16

FIG. 6